# EUROPEAN PATENT APPLICATION

(11) **EP 4 210 101 A2**
(43) Date of publication of application: **12.07.2023**
(21) Application number: 22206295.2
(22) Date of filing: 09.11.2022
(51) Int. Cl.: H01L 23/528, H01L 21/74, H01L 21/768, H01L 23/535, H01L 27/02, H01L 27/092

(54) **METAL-SEMICONDUCTOR JUNCTION FORMED BY A BURIED POWER RAIL**

(30) Priority: 16.12.2021 US 202117552683
(71) Applicant: INTEL Corporation, Santa Clara, CA 95054 (US)
(72) Inventor: GEIGER, Richard, 80939 Munich (DE); Panagopoulos, Georgios, 80539 Munich (DE); Rauh, Johannes, 85614 Kirchseeon (DE); Gossner, Harald, 85521 Riemerling (DE)
(74) Representative: Goddar, Heinz J.

(57) **Abstract**

IC devices including IC devices including BPRs that form metal-semiconductor junctions with semiconductor sections where the BPRs are partially buried are disclosed. An example IC device includes a first layer comprising semiconductor structures, such as fins, nanowires, or nanoribbons. The IC device also includes a layer comprising an electrically conductive material and coupled to the semiconductor structures. The IC device further includes a support structure comprising a BPR and a semiconductor section. The BPR contacts with the semiconductor section and forms a metal-semiconductor junction. The metal-semiconductor junction constitutes a Schottky barrier for electrons. The IC device may include a SCR including a sequence of p-well, n-well, p-well, and n-well with Schottky barriers in the first p-well and the second n-well. The Schottky barrier may also be used as a guard ring to extract injected charge carriers.

## Description

### Technical Field

This disclosure relates generally to the field of semiconductor devices, and more specifically, to integrated circuit (IC) devices.

### Background

For the past several decades, the scaling of features in ICs has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. Buried power rails (BPRs) can be a key scaling booster for complementary metal-oxide-semiconductor (CMOS) extension, e.g., beyond the 5-nm node.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a perspective view of an example fin-based field-effect transistor (FET), or FinFET, according to some embodiments of the disclosure.
FIG. 2 is a perspective view of an example IC device including BPRs forming metal-semiconductor junctions with a semiconductor section, according to some embodiments of the disclosure.
FIG. 3 is a cross-sectional view of an example IC device including BPRs forming dielectric-semiconductor junctions with a semiconductor section, according to some embodiments of the disclosure.
FIG. 4 is a cross-sectional view of an example IC device including BPRs forming metal-semiconductor junctions with a semiconductor section, according to some embodiments of the disclosure.
FIG. 5 is a cross-sectional view of an example IC device including a BPR-based silicon controlled rectifier (SCR), according to some embodiments of the disclosure.
FIG. 6 is a cross-sectional view of another example IC device including a BPR-based silicon SCR, according to some embodiments of the disclosure.
FIG. 7 is a cross-sectional view of an example IC device including a BPR-based guard ring formed by BPRs, according to some embodiments of the disclosure.
FIG. 8 is a top view of the IC device in FIG. 7, according to some embodiments of the disclosure.
FIG. 9 is a cross-sectional view of another example IC device including a BPR-based guard ring, according to some embodiments of the disclosure.
FIG. 10 is a top view of the IC device in FIG. 9, according to some embodiments of the disclosure.
FIGS. 11A-11B are top views of a wafer and dies that may include one or more metal-semiconductor junctions formed by BPRs, according to some embodiments of the disclosure.
FIG. 12 is a side, cross-sectional view of an example IC package that may include one or more IC devices having metal-semiconductor junctions formed by BPRs, according to some embodiments of the disclosure.
FIG. 13 is a cross-sectional side view of an IC device assembly that may include components having one or more IC devices implementing metal-semiconductor junctions formed by BPRs, according to some embodiments of the disclosure.
FIG. 14 is a block diagram of an example computing device that may include one or more components with metal-semiconductor junctions formed by BPRs, according to some embodiments of the disclosure.

### Detailed Description

### Overview

The systems, methods, and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC devices with metal-semiconductor junctions formed by BPRs, proposed herein, it might be useful to first understand phenomena that may come into play in such structures. The following foundational information may be viewed as a basis from which the present disclosure may be properly explained. Such information is offered for purposes of explanation only and, accordingly, should not be construed in any way to limit the broad scope of the present disclosure and its potential applications. While some of the following descriptions may be provided for the example of transistors being implemented as FinFETs, nanoribbon FETs, or nanosheet FETs, embodiments of the present disclosure are equally applicable to IC devices employing transistors of other architectures, such as nanoribbon or nanowire transistors, as well as to planar transistors.

Relentless scaling of transistors and wires in advanced semiconductor technologies has not only resulted in major process-related challenges but has also imposed severe design challenges in the sub-5nm technology regime. Dimensional scaling of designs has been made possible by (i) Front-End-of-Line (FEOL) and Back-End-of-Line (BEOL) pitch scaling, which worsens short-channel effects in transistors and increases wire/contact resistances; and, (ii) fin depopulation in logic cells, which causes degradation of transistor drive. To enable further area scaling in sub-5nm nodes, an approach of burying the power rails into the substrate has been proposed, which no longer requires reserving two routing tracks for power nets (e.g., VDD or VSS) in the logic cell area. Additionally, these BPRs can achieve a higher aspect ratio, thus, exhibiting lower resistance than local level BEOL power rails. BPRs can be a key scaling booster for complementary metal-oxide-semiconductor (CMOS) extension beyond the 5-nm node. Power lines which conventionally run outside substrates can be replaced with power lines "buried" within substrates, such as shallow trench isolation (STI) and Si substrate. Such power lines are called BPRs. A BPR is a power rail that is at least partially buried in a support structure, e.g., a substrate, die, etc. A BPR includes an electrically conductive material, such as metal. A rail can have an elongated structure having a longitudinal axis, which may be parallel to the frontside surface or the backside surface of the support structure. BPR frees up routing resources, which results in logic cell height reduction and overall area scaling.

The scaling in IC features brings new technical challenges. In one example, the robustness of transistors has seen a continuous decrease owing to the lower breakdown voltage for thinner gate oxides. Therefore, the protection of the gates from any electrostatic discharge (ESD) currents gets increasingly difficult to achieve, especially as high-speed applications put strict requirements towards any added loading capacitance at the protected pins, as well. For low capacitance ESD protection circuitry for Highspeed and RF, SCR are one of the key components. In bulk CMOS processes, they are typically incorporated in the form of a n+/p-well/n-well/p+ four-layer structure. With shift of the n+ and p+ regions into the fins the SCR path becomes longer. By this the turn-on time of the SCR increases and the holding voltage will go up. Together this degrades the voltage clamping capability and the ESD performance. This will further decline when going to a gate all around (GAA) technology due to the high ohmic path from the source/drain region to substrate. In planar CMOS and FinFET technologies the SCR is formed by highly doped regions placed in wells of opposite doping type. These become more and more inefficient in downscaled FinFET and even more in GAA technology.

In another example, intrinsic latch-up (a type of short circuit that can occur in ICs) sensitivity becomes more critical due to shrinking dimensions and higher resistance of wells and well contacts. Classical guarding contacts implemented by FinFET arrays will become less effective in gate all around technologies (GAA) due to a reduced contact area to the substrate region. There is the need of effective latch-up guard rings. A latch-up guard ring is a component in an IC that prevents or minimizes latch-ups to protect other components in the IC. Previous planar and FinFET technologies have used well guard rings, which are connected to VSS or VDD by source /drain regions of transistors. These well guard rings are implemented either as n+ or p+ implantation in a planar technology or by raised S/D regions of the FinFET transistors. The well which collects the injected carriers to the substrate are connected to VSS and VCC rails through the FinFET base region and the S/D region of the fin. With downscaling, the width of the fins is reduced below 10 nm and also the fin base region can be very narrow despite the trapezoidal shape. This leads to high resistance and low effectiveness of the guard ring per area.

The present invention relates to IC devices including BPRs forming metal-semiconductor junctions with semiconductor sections. An IC device includes semiconductor structures, an electrically conductive layer, a BPR, and a semiconductor section. The electrically conductive layer is electrically coupled to the semiconductor structures and the BPR for delivering power to the semiconductor structures. At least a portion of the BPR is buried in the semiconductor section. The BPR does not have a dielectric barrier. Rather, the BPR and the semiconductor section has a metal-semiconductor junction, which constitutes a Schottky barrier for charges.

An example of the IC device includes a SCR based on two BPRs. The SCR includes a sequence of p-well, n-well, p-well, and n-well. The first BPR forms a Schottky barriers with the first p-well. The second BPR forms another Schottky barrier with the second n-well. In an embodiment, the first BPR is coupled to a ground plane of the IC device and the second BPR is coupled to the power plane of the IC device. The second BPR may also be coupled to an IO (input/output) pad providing input/output signals to the IC device.

Another example of the IC device includes a p-well and a n-well enclosing the p-well. Two BPRs are buried in the p-well and n-well, respectively, and form Schottky barriers with the p-well and n-well. The BPRs are coupled to a power plane and a ground plane, respectively. Thus, the Schottky barriers are connected to the power and ground plane and therefore, forms a latch-up guard ring that can extract injected charges to prevent shorting between the power and ground planes. The BPR coupled to the power plane may be connected to a TSV (through-substrate-via) in the semiconductor section. A TSV is a via, at least a portion of which is inside the support structure. A TSV may extend along a direction from the frontside surface of the support structure to the backside surface of the support structure. A TSV may have a longitudinal axis that is perpendicular (or substantially perpendicular) to the frontside surface or the backside surface of the support structure. The TSV connects the BPR to an electrically conductive layer at the backside of the IC device. The conductive path formed by the BPR and TSV from the power plane to the electrically conductive layer at the backside can enhance the efficiency of extracting charges and therefore, enhances efficiency of the latch-up guard ring.

Elongated structures are mentioned throughout the present description. As used herein, a structure is referred to as an elongated if a length of the structure (measured alone one axis of an example coordinate system) is greater than both a width of the structure (measured alone another axis of the example coordinate system) and a height of the structure (measured alone a third axis of the example coordinate system). For example, elongated semiconductor structures as described herein may be fins or nanoribbons, having a length measured along an x-axis of the coordinate system shown in the present drawings, a width measured along a y axis of the coordinate system shown in the present drawings, and a height measured along a z-axis of the coordinate system shown in the present drawings. Because BPRs described herein, as well as openings above them, are substantially parallel to the semiconductor structures, their lengths, widths, and heights are also measured along, respectively, an x-axis, a y axis, and a z-axis of the x-y-z coordinate system shown in the present drawings. On the other hand, when the metal gate lines are substantially perpendicular to the semiconductor structures, as shown in the embodiments of the present drawings, their lengths, widths, and heights are measured along, respectively, a y axis, an x-axis, and a z-axis of the x-y-z coordinate system shown.

While some of the descriptions provided herein refer to FinFETs, these descriptions are equally applicable to embodiments any other non-planar FETs besides FinFETs, e.g., to nanoribbon transistors, nanowire transistors, or transistors such as nanoribbon/nanowire transistors but having transverse cross-sections of any geometry (e.g., oval, or a polygon with rounded corners).

IC devices as described herein, in particular IC devices with metal-semiconductor junctions formed by BPRs as described herein, may be used for providing electrical connectivity to one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

Further, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, such a collection may be referred to herein without the letters.

In the drawings, some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number of fins, a certain number of metal gate lines, a certain number of gate cuts, a certain number of stacked trench contacts, etc.), this is simply for ease of illustration, and more, or less, than that number may be included in an IC device with at least one gate cut above at least one BPR as described herein. Still further, various views shown in some of the drawings are intended to show relative arrangements of various elements therein. In other embodiments, various IC devices with gate cuts above BPRs as described herein, or portions thereof, may include other elements or components that are not illustrated (e.g., transistor portions, various components that may be in electrical contact with any of the metal lines, etc.). Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., Physical Failure Analysis (PFA) would allow determination of presence of IC devices with gate cuts above BPRs as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

For example, some descriptions may refer to a particular source or drain region or contact being either a source region/contact or a drain region/contact. However, unless specified otherwise, which region/contact of a transistor is considered to be a source region/contact and which region/contact is considered to be a drain region/contact is not important because under certain operating conditions, designations of source and drain are often interchangeable. Therefore, descriptions provided herein may use the term of a "S/D" region/contact to indicate that the region/contact can be either a source region/contact, or a drain region/contact.

In another example, if used, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple sub-elements. For example, "an electrically conductive material" may include one or more electrically conductive materials.

In another example, if used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide.

In yet another example, a term "interconnect" may be used to describe any element formed of an electrically conductive material for providing electrical connectivity to one or more components associated with an IC or/and between various such components. In general, the "interconnect" may refer to both conductive lines/wires (also sometimes referred to as "lines" or "metal lines" or "trenches") and conductive vias (also sometimes referred to as "vias" or "metal vias"). In general, a term "conductive line" may be used to describe an electrically conductive element isolated by a dielectric material typically comprising an interlayer low-k dielectric that is provided within the plane of an IC chip. Such conductive lines are typically arranged in several levels, or several layers, of metallization stacks. On the other hand, the term "conductive via" may be used to describe an electrically conductive element that interconnects two or more conductive lines of different levels of a metallization stack. To that end, a via may be provided substantially perpendicularly to the plane of an IC chip or a support structure over which an IC device is provided and may interconnect two conductive lines in adjacent levels or two conductive lines in not adjacent levels. A term "metallization stack" may be used to refer to a stack of one or more interconnects for providing connectivity to different circuit components of an IC chip.

Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function.

The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

### Example FinFET

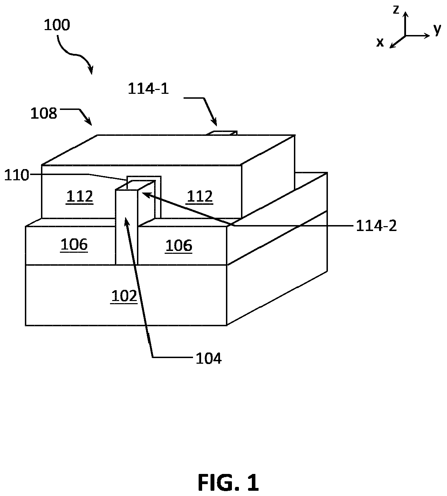

FIG. 1 is a perspective view of an example FinFET 100, according to some embodiments of the disclosure. The FinFET 100 illustrates one example of a transistor that can be placed over or at least partially inside a support structure. The FinFET 100 shown in FIG. 1 is intended to show relative arrangement(s) of some of the components therein. In various embodiments, the FinFET 100, or portions thereof, may include other components that are not illustrated (e.g., any further materials, such as spacer materials, surrounding the gate stack of the FinFET 100, electrical contacts to the S/D regions of the FinFET 100, etc.).

As shown in FIG. 1, the FinFET 100 may be provided over a support structure 102, where the support structure 102 may be any suitable support structure on which a transistor may be built, e.g., a substrate, a die, a wafer, or a chip. As also shown in FIG. 1, the FinFET 100 may include a fin 104, extending away from the support structure 102. A portion of the fin 104 that is closest to the support structure 102 may be enclosed by an insulator material 106, commonly referred to as an "STI material" or, simply, "STI." The portion of the fin 104 enclosed on its' sides by the STI 106 is typically referred to as a "subfin portion" or simply a "subfin." As further shown in FIG. 1, a gate stack 108 that includes at least a layer of a gate electrode material 112 and, optionally, a layer of a gate dielectric 110, may be provided over the top and sides of the remaining upper portion of the fin 104 (e.g., the portion above and not enclosed by the STI 106), thus wrapping around the upper-most portion of the fin 104. The portion of the fin 104 over which the gate stack 108 wraps around may be referred to as a "channel portion" of the fin 104 because this is where, during operation of the FinFET 100, a conductive channel may form. The channel portion of the fin 104 is a part of an active region of the fin 104. A first S/D region 114-1 and a second S/D region 114-2 (also commonly referred to as "diffusion regions") are provided on the opposite sides of the gate stack 108, forming source and drain terminals of the FinFET 100.

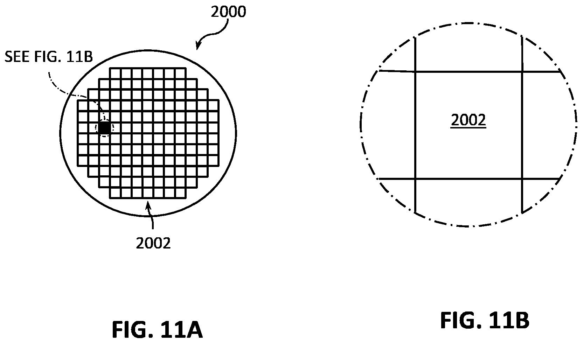

In general, implementations of the present disclosure may be formed or carried out on a support structure such as a semiconductor substrate, composed of semiconductor material systems including, for example, n-type or p-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the support structure 102 may be a printed circuit board (PCB) substrate. Although a few examples of materials from which the substrate may be formed are described here, any material that may serve as a foundation upon which IC devices implementing signal routing using structures based on BPRs as described herein may be built falls within the spirit and scope of the present disclosure. In various embodiments, the support structure 102 may include any such substrate material that provides a suitable surface for forming the FinFET 100. The support structure 102 may, e.g., be the wafer 2000 of FIG. 11A, discussed below, and may be, or be included in, a die, e.g., the singulated die 2002 of FIG. 11B, discussed below.

As shown in FIG. 1, the fin 104 may extend away from the support structure 102 and may be substantially perpendicular to the support structure 102. The fin 104 may include one or more semiconductor materials, e.g., a stack of semiconductor materials, so that the upper-most portion of the fin (namely, the portion of the fin 104 enclosed by the gate stack 108) may serve as the channel region of the FinFET 100. Therefore, as used herein, the term "channel material" of a transistor may refer to such upper-most portion of the fin 104, or, more generally, to any portion of one or more semiconductor materials in which a conductive channel between source and drain regions may be formed during operation of a transistor.

As shown in FIG. 1, the STI material 106 may enclose the sides of the fin 104. A portion of the fin 104 enclosed by the STI 106 forms a subfin. In various embodiments, the STI material 106 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 106 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

Above the subfin portion of the fin 104, the gate stack 108 may wrap around the fin 104 as shown in FIG. 1. In particular, the gate dielectric 110 may wrap around the upper-most portion of the fin 104, and the gate electrode 112 may wrap around the gate dielectric 110. The interface between the channel portion of the fin 104 and the subfin portion of the fin 104 is located proximate to where the gate electrode 112 ends.

The gate electrode 112 may include one or more gate electrode materials, where the choice of the gate electrode materials may depend on whether the FinFET 100 is a p-type metal-oxide-semiconductor (PMOS) transistor or an n-type metal-oxide-semiconductor (NMOS) transistor. For a PMOS transistor, gate electrode materials that may be used in different portions of the gate electrode 112 may include, but are not limited to, ruthenium, palladium, platinum, cobalt, nickel, and conductive metal oxides (e.g., ruthenium oxide). For an NMOS transistor, gate electrode materials that may be used in different portions of the gate electrode 112 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 112 may include a stack of a plurality of gate electrode materials, where zero or more materials of the stack are workfunction (WF) materials and at least one material of the stack is a fill metal layer. Further materials/layers may be included next to the gate electrode 112 for other purposes, such as to act as a diffusion barrier layer or/and an adhesion layer.

If used, the gate dielectric 110 may include a stack of one or more gate dielectric materials. In some embodiments, the gate dielectric 110 may include one or more high-k dielectric materials. In various embodiments, the high-k dielectric materials of the gate dielectric 110 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 110 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 110 during manufacture of the FinFET 100 to improve the quality of the gate dielectric 110.

In some embodiments, the gate stack 108 may be surrounded by a dielectric spacer, not specifically shown in FIG. 1. The dielectric spacer may be configured to provide separation between the gate stacks 108 of different FinFETs 100 which may be provided along a single fin (e.g., different FinFETs provided along the fin 104, although FIG. 1 only illustrates one of such FinFETs), as well as between the gate stack 108 and the source/drain contacts disposed on each side of the gate stack 108. Such a dielectric spacer may include one or more low-k dielectric materials. Examples of the low-k dielectric materials that may be used as the dielectric spacer include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the dielectric spacer include organic polymers such as polyimide, polynorbornenes, benzocyclobutene, perfluorocyclobutane, or polytetrafluoroethylene (PTFE). Still other examples of low-k dielectric materials that may be used as the dielectric spacer include silicon-based polymeric dielectrics such as hydrogen silsesquioxane (HSQ) and methylsilsesquioxane (MSQ). Other examples of low-k materials that may be used in a dielectric spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1. When such a dielectric spacer is used, then the lower portions of the fin 104, e.g., the subfin portion of the fin 104, may be surrounded by the STI material 106 which may, e.g., include any of the high-k dielectric materials described herein.

In some embodiments, the fin 104 may be composed of semiconductor material systems including, for example, n-type or p-type materials systems. In some embodiments, the fin 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the fin 104 may include a combination of semiconductor materials where one semiconductor material is used for the channel portion and another material, sometimes referred to as a "blocking material," is used for at least a portion of the subfin portion of the fin 104. In some embodiments, the subfin and the channel portions of the fin 104 are each formed of monocrystalline semiconductors, such as silicon or germanium. In a first embodiment, the subfin and the channel portion of the fin 104 are each formed of compound semiconductors with a first sub-lattice of at least one element from group III of the periodic table (e.g., Al, Ga, In), and a second sub-lattice of at least one element of group V of the periodic table (e.g., P, As, Sb). The subfin may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth.

For some example n-type transistor embodiments (i.e., for the embodiments where the FinFET 100 is an NMOS), the channel portion of the fin 104 may advantageously include a III-V material having a high electron mobility, such as, but not limited to InGaAs, InP, InSb, and InAs. For some such embodiments, the channel portion of the fin 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel portion of the fin 104 may be an intrinsic III-V material, i.e., a III-V semiconductor material not intentionally doped with any electrically active impurity. In alternate embodiments, a nominal impurity dopant level may be present within the channel portion of the fin 104, for example to further fine-tune a threshold voltage Vt, or to provide HALO pocket implants, etc. Even for impurity-doped embodiments however, impurity dopant level within the channel portion of the fin 104 may be relatively low, for example below 10¹⁵ dopant atoms per cubic centimeter (cm⁻³), and advantageously below 10¹³ cm⁻³. The subfin portion of the fin 104 may be a III-V material having a band offset (e.g., conduction band offset for n-type devices) from the channel portion. Example materials include, but are not limited to, GaAs, GaSb, GaAsSb, GaP, InAIAs, GaAsSb, AlAs, AIP, AlSb, and AIGaAs. In some n-type transistor embodiments of the FinFET 100 where the channel portion of the fin 104 is InGaAs, the subfin may be GaAs, and at least a portion of the subfin may also be doped with impurities (e.g., p-type) to a greater impurity level than the channel portion. In an alternate heterojunction embodiment, the subfin and the channel portion of the fin 104 are each, or include, group IV semiconductors (e.g., Si, Ge, SiGe). The subfin of the fin 104 may be a first elemental semiconductor (e.g., Si or Ge) or a first SiGe alloy (e.g., having a wide bandgap).

For some example p-type transistor embodiments (i.e., for the embodiments where the FinFET 100 is a PMOS), the channel portion of the fin 104 may advantageously be a group IV material having a high hole mobility, such as, but not limited to Ge or a Ge-rich SiGe alloy. For some example embodiments, the channel portion of the fin 104 may have a Ge content between 0.6 and 0.9, and advantageously may be at least 0.7. In some embodiments with highest mobility, the channel portion may be intrinsic III-V (or IV for p-type devices) material and not intentionally doped with any electrically active impurity. In alternate embodiments, one or more a nominal impurity dopant level may be present within the channel portion of the fin 104, for example to further set a threshold voltage Vt, or to provide HALO pocket implants, etc. Even for impurity-doped embodiments however, impurity dopant level within the channel portion is relatively low, for example below 10¹⁵ cm⁻³, and advantageously below 10¹³ cm⁻³. The subfin of the fin 104 may be a group IV material having a band offset (e.g., valance band offset for p-type devices) from the channel portion. Example materials include, but are not limited to, Si or Si-rich SiGe. In some p-type transistor embodiments, the subfin of the fin 104 is Si and at least a portion of the subfin may also be doped with impurities (e.g., n-type) to a higher impurity level than the channel portion.

Turning to the first S/D region 114-1 and the second S/D region 114-2 on respective different sides of the gate stack 108, in some embodiments, the first S/D region 114-1 may be a source region and the second S/D region 114-2 may be a drain region. In other embodiments this designation of source and drain may be interchanged, i.e., the first S/D region 114-1 may be a drain region and the second S/D region 114-2 may be a source region. Although not specifically shown in FIG. 1, the FinFET 100 may further include S/D electrodes (also commonly referred to as "S/D contacts"), formed of one or more electrically conductive materials, for providing electrical connectivity to the S/D regions 114, respectively. In some embodiments, the S/D regions 114 of the FinFET 100 may be regions of doped semiconductors, e.g., regions of doped channel material of the fin 104, so as to supply charge carriers for the transistor channel. In some embodiments, the S/D regions 114 may be highly doped, e.g., with dopant concentrations of about 1·10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions 114 of the FinFET 100 are the regions having dopant concentration higher than in other regions, e.g., higher than a dopant concentration in a region of the semiconductor channel material between the first S/D region 114-1 and the second S/D region 114-2, and, therefore, may be referred to as "highly doped" (HD) regions.

In some embodiments, the S/D regions 114 may generally be formed using either an implantation/diffusion process or an etching/deposition process. In the former process, dopants such as boron, aluminum, antimony, phosphorous, or arsenic may be ion-implanted into the one or more semiconductor materials of the upper portion of the fin 104 to form the S/D regions 114. An annealing process that activates the dopants and causes them to diffuse further into the fin 104 may follow the ion implantation process. In the latter process, the one or more semiconductor materials of the fin 104 may first be etched to form recesses at the locations for the future source and drain regions. An epitaxial deposition process may then be carried out to fill the recesses with material (which may include a combination of different materials) that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. Although not specifically shown in the perspective illustration of FIG. 1, in further embodiments, one or more layers of metal and/or metal alloys may be used to form the source and drain contacts (i.e., electrical contacts to each of the S/D regions 114).

The FinFET 100 may have a gate length, GL, (i.e., a distance between the first S/D region 114-1 and the second S/D region 114-2), a dimension measured along the longitudinal axis of the fin 104, which extends in the direction of the x-axis of the example reference coordinate system x-y-z shown in the present drawings, where the gate length may, in some embodiments, be between about 5 and 40 nanometers, including all values and ranges therein (e.g. between about 22 and 35 nanometers, or between about 15 and 25 nanometers). The fin 104 may have a thickness, a dimension measured in the direction of the y-axis of the reference coordinate system x-y-z shown in FIG. 1, that may, in some embodiments, be between about 4 and 15 nanometers, including all values and ranges therein (e.g., between about 5 and 10 nanometers, or between about 7 and 12 nanometers). The fin 104 may have a height, a dimension measured in the direction of the z-axis of the reference coordinate system x-y-z shown in FIG. 1, which may, in some embodiments, be between about 30 and 350 nanometers, including all values and ranges therein (e.g., between about 30 and 200 nanometers, between about 75 and 250 nanometers, or between about 150 and 300 nanometers).

Although the fin 104 is illustrated in FIG. 1 as having a rectangular cross-section in a z-y plane of the reference coordinate system shown in FIG. 1, the fin 104 may instead have a cross-section that is rounded or sloped at the "top" of the fin 104, and the gate stack 108 (including the different portions of the gate dielectric 110) may conform to this rounded or sloped fin 104. In use, the FinFET 100 may form conducting channels on three "sides" of the channel portion of the fin 104, potentially improving performance relative to single-gate transistors (which may form conducting channels on one "side" of a channel material or substrate) and double-gate transistors (which may form conducting channels on two "sides" of a channel material or substrate). While FIG. 1 illustrates a single FinFET 100, in some embodiments, a plurality of FinFETs may be arranged next to one another (with some spacing in between) along the fin 104.

Other types of semiconductor structures can be used in a FET. For example, nanoribbon-based FETs include elongated semiconductor structures called nanoribbons as semiconductor structures. As another example, nanowire-based FETs include nanowires as semiconductor structures. As used herein, the term "nanoribbon" refers to an elongated semiconductor structure having a longitudinal axis parallel to the support structure over which a memory device is provided. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections.

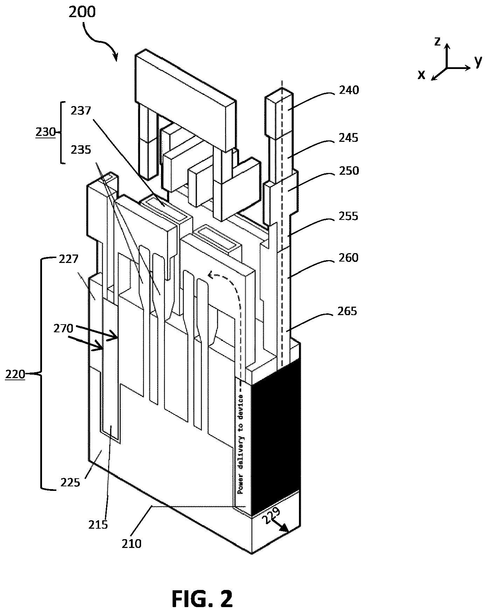

FIG. 2 is a perspective view of an example IC device 200 including BPRs 210 and 215 forming metal-semiconductor junctions with a semiconductor section 225, according to some embodiments of the disclosure. The IC device 200 includes a support structure 220 where the BPRs 210 and 215 are buried, transistors 230 (individually referred to as "transistor 230"), electrically conductive layers 240, 250, and 260, and vias 245, 255, and 265. In other embodiments, the IC device 200 may include more, fewer, or different components. In some embodiments, the components of the IC device 200 may be arranged differently. For instance, the electrically conductive layer 240 may be arranged below the support structure 220 for backside power delivery.

The support structure 220 includes a semiconductor section 225 and an insulator section 227. A portion of each BPR 210 or 215 is buried in the semiconductor section 225, and the remaining portion of the BPR 210 or 215 is buried in the insulator section 227. The semiconductor section 225 is a layer comprising a semiconductor material. Examples of the semiconductor material include, for example, single crystal silicon, polycrystalline silicon, silicon-on-insulator (SOI), other suitable semiconductor material, or some combination thereof. The semiconductor section 225 may also include other materials, such as metal, dielectric, dopant, and so on. In FIG. 2, the semiconductor section 225 has a top surface and a bottom surface. The top surface of the semiconductor section 225 contacts with the bottom surface of the insulator section 227. The bottom surface of the semiconductor section 225 is the bottom surface of the IC device 200 and can be referred to as the backside of the IC device 200. In some embodiments, the semiconductor section 225, or a portion of it, is dopped to generate a p-type support structure or n-type support structure.

The insulator section 227 is a layer comprising an insulator material, such as an oxide material. The insulator section 227 adjoins the semiconductor section 225. The insulator section 227 functions as an electrical insulator that isolates conducting and semiconducting materials from each other. In some embodiments, the insulator section 227 is an oxide layer. An example oxide layer is a layer of silicon oxide, SiOx, where x is an integer number, such as 2, 2, etc. The insulator section 227 adjoins the semiconductor section 225. As shown in FIG. 2, the insulator section 227 is above the semiconductor section 225. In some embodiments, the insulator layer 227 is not a continuous insulator layer. Rather, the insulator layer 227 includes discrete insulator sections arranged in the semiconductor material of the semiconductor layer 225. The discrete insulator sections can insulate BPRs from the semiconductor material. The discrete insulator sections can also insulate semiconductor structures, which are formed in the semiconductor layer 225, of transistors from each other. The discrete insulator sections may include an oxide of the semiconductor material and can be formed from portions of the semiconductor layer 225.

In some embodiments, the insulator section 227 may be formed by transforming a portion of a silicon support structure into silicon oxide. Silicon exposed to ambient conditions has a native oxide on its surface. The native oxide is approximately 3 nm thick at room temperature. However, 3 nm may be too thin for most applications and a thicker insulator layer needs to be grown. This is done by consuming the underlying Si to form SiOx. This is a grown layer. It is also possible to grow SiOx by a chemical vapor deposition process using Si and O precursor molecules. In this embodiment, the underlying Si in the wafer is not consumed. This is called a deposited layer. In some embodiments, the insulator section 227 helps in protecting the components in the support structure 220 from contamination, both physical and chemical. Thus, it acts as a passivating layer. The insulator section 227 can protect the components in the support structure 220 from scratches and it also prevents dust from interacting with the components in the support structure 220, and thus minimizes contamination. The insulator section 227 also protects the components in the support structure 220 from chemical impurities, mainly electrically active contaminants. SiOx acts as a hard mask for doping and as an etch stop during patterning.

The BPRs 210 and 215 are electrically conductive. The BPRs 210 and 215 are coupled to one or more power sources and to semiconductor devices in the IC device 200 (such as the transistors 230) to provide power to the semiconductor devices. For instance, the BPRs 210 and 215 are coupled to a power plane and a ground plane, respectively. In FIG. 2, the two BPRs 210 and 215 are buried in the support structure 220. A portion of each BPR 210 or 215 is buried in the insulator section 227. The remaining portion of each BPR 210 or 215 is buried in the semiconductor section 225. The BPRs 210 and 215 includes a metal, such as Tungsten, Rubidium, Molybdenum, other metals, or some combination thereof.

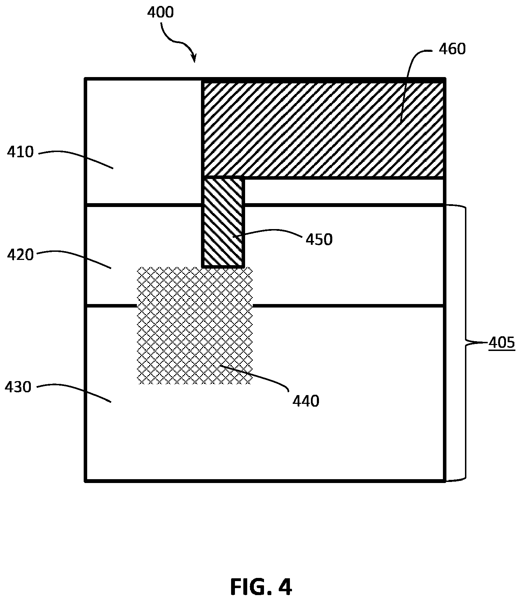

One or both of the BPRs 210 and 215 do not have any dielectric barriers separating the metal from the semiconductor section 225. Taking the BPR 215 as an example, the metal of the BPR 215 contacts directly with the semiconductor in the semiconductor section 225 and forms a metal-semiconductor junction. The metal-semiconductor junction constitutes a Schottky barrier. As the BPRs 210 is connected to the power or ground plane of the IC device 200, the Schottky barrier has a good contact with the power or ground planes. The BPR 215 may be formed by a deep trench, e.g., in the 50 -150 nm range. The deep trench is filled with the metal. In the process of forming the BPR 215, the deep trench is not covered by any insulating layers or liners to avoid formation of any insulating layers or liners that will separate the metal from the semiconductor in the semiconductor section 225. That can be done by using one mask to block or remove dielectric barriers inside the deep trench. More details regarding BPR-based Schottky barrier are provided below in conjunction with FIG. 4.

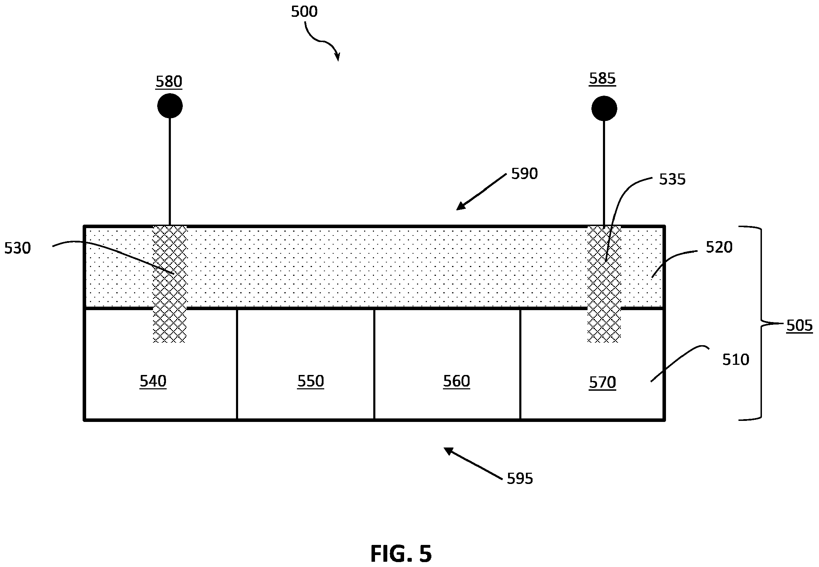

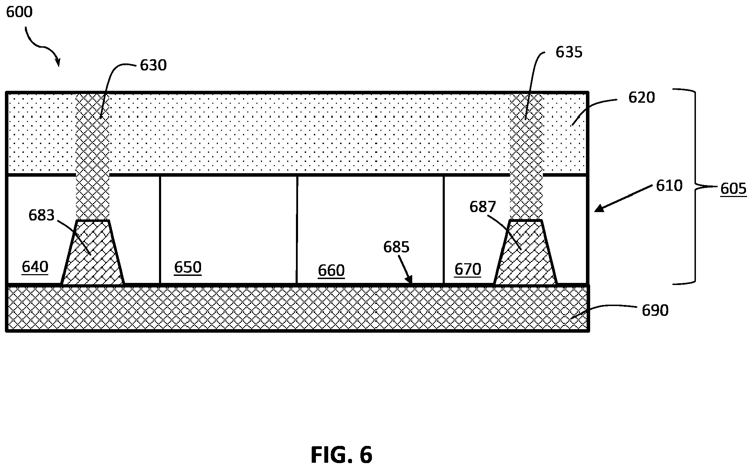

In some embodiments, a SCR is formed in the semiconductor section 225. The SCR includes a sequence of p-well, n-well, p-well, and n-well. The BPR 215 is partially enclosed by the first p-well and the BPR 210 is partially enclosed by the second n-well. Thus, the SCR is connected to the power and ground planes through the BPRs 210 and 215. With the Schottky barriers formed by the BPRs 210 and 215 with the semiconductor section 225, the SCR can provide ESD protection. More details regarding BPR-based SCR are provided below in conjunction with FIGS. 5 and 6.

In some embodiments, the BPRs 210 and 215 are ring-shaped and can form a latch-up guard ring. For instance, the BPR 210 is partially enclosed in a p-well in the semiconductor section 225 and the BPR 215 is partially enclosed in a n-well in the semiconductor section 225. The n-well may enclose the p-well and the BPR 215 may enclose the BPR 210. The Schottky barriers formed by the BPRs 210 and 215 with the semiconductor section 225 can extract charges to avoid shorting between the power plane and ground plane. More details regarding BPR-based latch-up guard ring are provided below in conjunction with FIGS. 5 and 6.

The electrically conductive layers 240, 250, and 260 are built in the IC device 200 to provide power and signal to the semiconductor devices in the IC device 200. An electrically conductive layer is a layer comprising an electrically conductive material, e.g., metal. In an embodiment, the electrically conductive layers 240 and 260 are used for power delivery but the electrically conductive layer 250 is used for signal delivery. In some embodiments, the electrically conductive layer 260 is referred to as "M0," the electrically conductive layer 250 is referred to as "Mint," and the electrically conductive layer 260 is referred to as "M1," given the sequence of producing the electrically conductive layers 240, 250, and 260 in the process of fabricating the IC device 200. The electrically conductive layers 240, 250, and 260 can be made of copper or other types of metals. Each electrically conductive layer 240, 250, or 260 includes multiple sections that can be separated and insulated from each other.

The BPRs 210 and 215, electrically conductive layers 240, 250, and 260, and vias 245, 255, and 265 constitute a conducting path for power delivery network, as indicated by the dotted line in FIG. 2. The vias 245, 255, and 265 are conducting. In one embodiment, some or all of the vias 245, 255, and 265 are made of copper or other types of metal. The vias 245 are between the electrically conductive layers 240 and 250 to connect the two electrically conductive layers 240 and 250 to each other. As shown in FIG. 2, there are three vias 245 between the electrically conductive layers 240 and 250. Each via 245 is for connecting a section of the electrically conductive layer 240 to a corresponding section of the electrically conductive layer 250. In other embodiments, there can be fewer or more vias 245 to connect the electrically conductive layers 240 and 250. Similarly, the via 255 is between the electrically conductive layers 250 and 260. The vias 265 connect the BPRs 210 and 215 to the electrically conductive layer 260. In FIG. 2, there are two vias 265 connecting the BPR 210 to the electrically conductive layer 260 and two vias 265 connecting the BPR 215 to the electrically conductive layer 260. The electrically conductive layer 260 is connected to the transistors 230, particularly the fins of the transistors 230.

In an example, the electrically conductive layer 240 functions as the power plane of the IC device 200. A positive or negative voltage, for example, can be provided to the electrically conductive layer 240 so that the BPR 210 is electrically biased. The BPR 215 is grounded so that there is an electric potential difference between the BPRs 210 and 215, which transfers to the electric potential difference between the transistors 230. As the electrically conductive layer 240 is on top of the transistors 230, the power delivery network is called "frontside power delivery network." In other embodiments, the IC device 200 may include an electrically conductive layer below the transistors 230, e.g., at the backside of the IC device 200. The electrically conductive layer may function as the power plane, ground plane, or both to form "backside power delivery network". The BPRs 210 and 215 can be connected to the electrically conductive layer with TSVs. The TSVs are below the BPRs 210 and 215 and buried in the semiconductor section 225 of the support structure 220. The TSVs may be micro-TSVs or nano-TSVs. The power delivery network of the IC device 200 can be a network of interconnect that is separate from the signal network. For instance, portions of the electrically conductive layer 250 that are not in the power delivery network can be used to deliver signals.

In some embodiments, the IC device 200 is fabricated through a sequence of processes. Well formation is done as the first step. The first step comprises, for example, ion implantation and dopant activation anneal. Alternatively, well formation can be done after the fin reveal step. Subsequently, fin patterning and insulator layer formation are carried out. The insulator layer formation step may include silicon oxide deposition, silicon oxide anneal, and chemical mechanical polishing (CMP). The BPRs 210 and 215 are formed in the next step, which includes patterning BPR trench into the support structure 220. Subsequently, a dielectric barrier may be deposited onto the outer surfaces of the BPRs 210 and 215 (i.e., the surfaces touching the support structure 220) to electrically isolate the BPRs 210 and 215 from the support structure 220. In some embodiments, the step of forming the BPRs 210 and 215 may further include metal CMP and silicon oxide anneal. Next, fin reveal is carried out, e.g., by etching, to reveal the fins. After that, the electrically conductive layers 240, 250, and 260 and vias 245, 255, and 265 are integrated into the IC device 200.

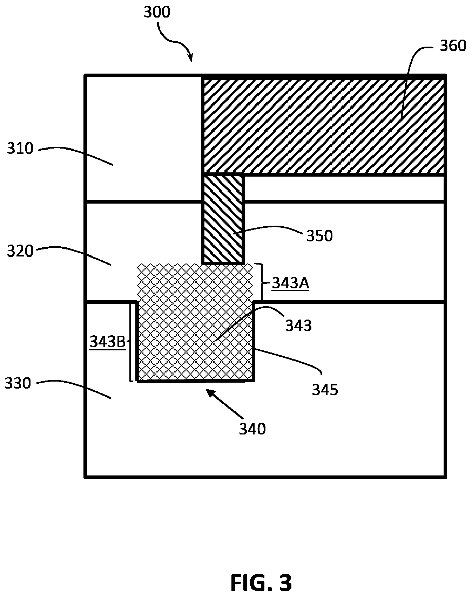

FIG. 3 is a cross-sectional view of an example IC device 300 including a BPR 340 forming a dielectric-semiconductor junction with a semiconductor section 330, according to some embodiments of the disclosure. The IC device 300 includes insulator sections 310 and 320 and the semiconductor section 330. An electrically conductive layer 360 is in the insulator section 310. The BPR 340 is buried in the insulator section 320 and semiconductor section 330. The BPR 340 is coupled to the electrically conductive layer 360 through a via 350. In other embodiments, the IC device 300 may include fewer, more, or different components. For instance, the IC device 300 includes transistors. The electrically conductive layer 360 may be electrically coupled to semiconductor structures of the transistors to provide electrical power to the semiconductor structures. Example semiconductor structures include fins, nanoribbons, nanosheets, and so on.

The insulator section 310 includes an electrical insulator to insulates the electrically conductive layer 360 and the via 350 from other components. Similarly, the insulator section 320 includes an electrical insulator to insulates the via 350 and the BPR 340 from other components, e.g., transistors. In some embodiments, the electrical insulator in the insulator section 310 or 320 is an oxide material, such as silicon oxide. The insulator section 320 adjoins the semiconductor section 330.

The semiconductor section 330 includes a semiconductor material, such as silicon. In some embodiments, a portion of or the whole semiconductor section 330 is doped to form a doped support structure, such as p-support structure or n-support structure. An embodiment of the semiconductor section is the semiconductor section 225 in FIG. 2.

The BPR 340 includes a metal core 343 and a dielectric barrier 345. The metal core 343 is connected to the via 350 for forming an electrically conductive path to the electrically conductive layer 360. In one embodiment, the metal core 343 is electrically coupled to a power plane or ground plane of the IC device 300. The metal core 343 forms a power delivery path with the via 350 and the electrically conductive layer 360. As shown in FIG. 3, a portion 343A of the metal core 343 is in the insulator section 320 and the remaining portion 343B of the metal core 343 is in the semiconductor section 330. The dielectric barrier 345 separates the portion 343B of the metal core 343 from the semiconductor section 330. In some embodiments, the dielectric barrier 345 includes an electrical insulator. The electrical insulator may be the same material as the electrical insulator of the insulator section 320. With the dielectric barrier 345, the BPR 340 and the semiconductor section 330 has a dielectric-semiconductor junction. In the embodiment of FIG. 3, the dielectric barrier 345 is not present in the insulator section 320 as the insulator section 320 is insulating itself. In other embodiments, the dielectric barrier 345 may be present in the insulator section 320 to separate the portion 343A of the metal core 343 from the insulator section 320.

FIG. 4 is a cross-sectional view of an example IC device 400 including a BPR 440 forming a metal-semiconductor junction with a semiconductor section 430, according to some embodiments of the disclosure. The IC device 400 includes an insulator section 410, a support structure 405 including another insulator section 420 and the semiconductor section 430, a via 450, and an electrically conductive layer 460. The electrically conductive layer 460 is in the insulator section 410. The BPR 440 is buried in the insulator section 420 and semiconductor section 430. The BPR 440 is coupled to the electrically conductive layer 460 by the via 450. In other embodiments, the IC device 400 may include fewer, more, or different components. For instance, the IC device 400 includes transistors. The BPR 440 and electrically conductive layer 460 may be electrically coupled to semiconductor structures of the transistors to provide electrical power to the semiconductor structures. Example semiconductor structures include fins, nanoribbons, nanosheets, and so on.

The insulator section 410 includes an electrical insulator to insulates the electrically conductive layer 460 and the via 450 from other components. Similarly, the insulator section 420 includes an electrical insulator to insulates the via 450 and the BPR 440 from other components, e.g., transistors. In some embodiments, the electrical insulator in the insulator section 410 or 420 is an oxide material, such as silicon oxide. The insulator section 420 adjoins the semiconductor section 430.

The semiconductor section 430 includes a semiconductor material, such as silicon. In some embodiments, a portion of or the whole semiconductor section 430 is doped to form a doped support structure, such as p-support structure or n-support structure. An embodiment of the semiconductor section is the semiconductor section 225 in FIG. 2.

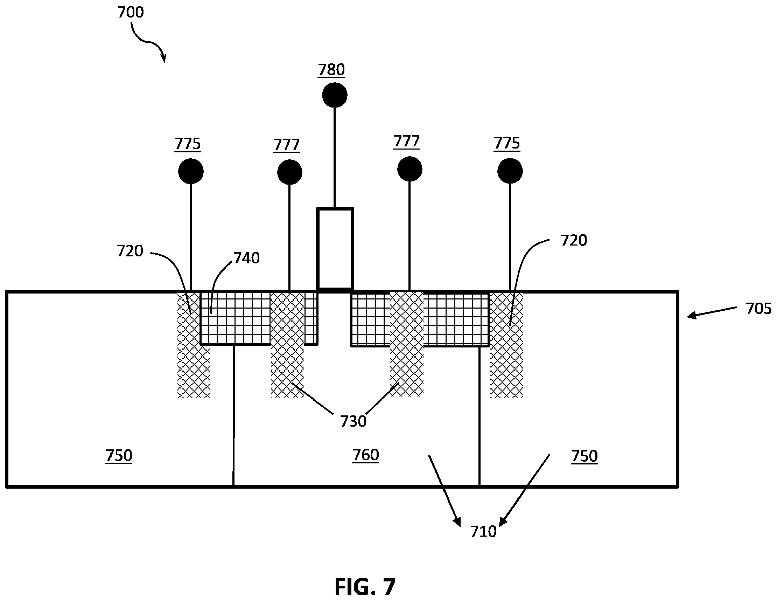

Different from the BPR 340 in FIG. 3, the BPR 440 does not include a dielectric barrier. The whole BPR 440 is conductive. The BPR 440 may include a metal, such as Tungsten, Rubidium or Molybdenum. Therefore, the BPR 440 forms a metal-semiconductor junction with the semiconductor section 430. The metal-semiconductor junction constitutes a Schottky barrier, which is a potential energy barrier for electrons formed at the metal-semiconductor junction. Schottky barrier can have rectifying characteristics. For instance, the Schottky barrier can convert an alternating current, which periodically reverses directions, to a direct current, which flows in only one direction. In some embodiments, the metal-semiconductor junction between the BPR 440 and the semiconductor section 430 can be used to form a SCR for low capacitance ESD protection. Example of such SCRs are described below in conjunction with FIGS. 5 and 6. In other embodiments, the metal-semiconductor junction between the BPR 440 and the semiconductor section 430 can be used to form a latch-up guard ring to extract injected charge carriers. Examples of such latch-up guard rings are described below in conjunction with FIGS. 7-10.

FIG. 5 is a cross-sectional view of an example IC device 500 including a BPR-based SCR, according to some embodiments of the disclosure. The IC device 500 includes a support structure 505, a ground plane 580, and a power plane 585. In other embodiments, the IC device 500 may include different components. For instance, the IC device 500 may include semiconductor structures of one or more transistors.

The support structure 505 includes a semiconductor section 510, an insulator section 520, and BPRs 530 and 535. The semiconductor section 510 may be an embodiment of the semiconductor section 430 in FIG. 4. The insulator section 520 may be an embodiment of the insulator section 420 in FIG. 4. The insulator section 520 adjoins the semiconductor section 530. The BPRs 530 and 535 are embodiments of the BPR 440 in FIG. 4. As shown in FIG. 5, he BPRs 530 and 535 are buried in the semiconductor section 510 and insulator section 520. A portion of each BPR 530 or 535 contacts with semiconductor section 510. As the BPRs 530 and 535 do not have dielectric barriers, they form Schottky barriers with the semiconductor section 510. The Schottky barriers are used to form the SCR.

The SCR is four-layer solid-state current-controlling device. In the embodiment of FIG. 5, the SCR is a four-layer structure of four wells: p-type semiconductor element 540, n-type semiconductor element 550, p-type semiconductor element 560, and n-type semiconductor element 570 that are arranged in a sequence. The sequence has an order of the p-type semiconductor element 540, n-type semiconductor element 550, p-type semiconductor element 560, and n-type semiconductor element 570 as shown in FIG. 5. The p-type semiconductor element 540, n-type semiconductor element 550, p-type semiconductor element 560, and n-type semiconductor element 570 are formed in the semiconductor section 510. A p-type semiconductor element may be a p-well. A n-type semiconductor element may be a n-well. The BPRs 530 and 535 contacts with the p-type semiconductor element 540 and n-type semiconductor element 570 (the two outermost wells of the SCR), respectively. The BPR 530 and p-type semiconductor element 540 forms a metal-semiconductor junction. The BPR 535 and n-type semiconductor element 570 forms another metal-semiconductor junction. In some embodiments, the BPRs 530 and 535 are coupled to semiconductor structures of transistors and delivery power to the semiconductor structures.

In some embodiments, the BPRs 530 and 535 are formed by deep trenches, e.g., in the 50 - 150 nm range. Each deep trench can be filled with a metal, such as Tungsten, Rubidium, Molybdenum, and so on. In the process of forming the BPRs 530 and 535, the deep trench is not covered by any insulating layers or liners to avoid formation of any insulating layers or liners that will separate the metal from the semiconductor in the semiconductor section 510. The formation of the SCR can be done by using a mask to block or remove dielectric barriers inside the trench so that the BPRs 530 and 535 do not have the dielectric barriers. Given the presence of the metal-semiconductor junctions/Schottky barriers, the SCR conducts current only in one direction. For example, the SCR can be triggered by a positive current applied to the SCR.

In FIG. 5, the BPR 530 is connected to the ground plane 580 and the BPR 535 is connected to the power plane 585. The BPR 535 may also be connected to an IO pad. Through the BPRs 530 and 535, the SCR is formed deep inside the semiconductor section 510 with a good contact to the ground plane 580 and power plane 585. Thus, the SCR can provide efficient ESD protection, e.g., to transistors or other types of active devices coupled to the BPRs 530 and 535. Also, the structure of the SCR allows the option to contact the electrodes by TSVs from the backside. Even though not shown in FIG. 5, the BPRs 530 and 535 can be electrically coupled to an electrically conductive layer through vias. The electrically conductive layer may be coupled to semiconductor structures of transistors, so that the BPRs 530 and 535 together with the electrically conductive layer deliver power to the semiconductor structures. FIG. 5 shows an embodiment of frontside power delivery by the BPRs 530 and 535 as the ground plane 580 and power plane 585 are at the frontside 590 of the IC device 500. In other embodiments, the BPRs 530 and 535 can be connected to an electrically conductive layer arranged at the backside of the IC device 500 to form a backside power delivery path.

FIG. 6 is a cross-sectional view of another example IC device 600 including a BPR-based SCR, according to some embodiments of the disclosure. The IC device 600 includes a support structure 605 and an electrically conductive layer 690. In other embodiments, the IC device 500 may include different components. For instance, the IC device 600 may include semiconductor structures of one or more transistors.

The support structure 605 includes a semiconductor section 610, an insulator section 620, BPRs 530 and 535, and TSVs 683 and 687. The semiconductor section 610 is similar to the semiconductor section 510 in FIG. 5 and may be an embodiment of the semiconductor section 430 in FIG. 4. The insulator section 620 is similar to the insulator section 520 in FIG. 5. As shown in FIG. 6, the insulator section 620 adjoins the semiconductor section 610. The insulator section 620 insulates the BPRs 630 and 635 from each other. In some embodiments, the insulator section 620 includes an electrical insulator, such as silicon oxide. The BPRs 530 and 535 are buried in the semiconductor section 610 and insulator section 620. A portion of each BPR 530 or 535 contacts with the insulator section 620. The remaining portion of the BPR 530 or 535 contacts with the semiconductor section 610. The BPRs 630 and 636 do not have dielectric barriers separating them from the semiconductor section 610, so the BPRs 630 and 636 form Schottky barriers with the semiconductor section 610. The SCR is based on the Schottky barriers.

Similar to the SCR in the IC device 500, the SCR in the IC device 600 is four-layer solid-state current-controlling device. In the embodiment of FIG. 6, the SCR is a four-layer structure of four wells: p-type semiconductor element 640, n-type semiconductor element 650, p-type semiconductor element 660, and n-type semiconductor element 670 that are arranged in a sequence. The sequence has an order of the p-type semiconductor element 640, n-type semiconductor element 650, p-type semiconductor element 660, and n-type semiconductor element 670 as shown in FIG. 6. The p-type semiconductor element 640, n-type semiconductor element 650, p-type semiconductor element 660, and n-type semiconductor element 670 are formed in the semiconductor section 610. A p-type semiconductor element may be a p-well. A n-type semiconductor element may be a n-well. The BPRs 630 and 636 contacts with the p-type semiconductor element 640 and n-type semiconductor element 670 (the two outermost wells of the SCR), respectively. The BPR 630 and p-type semiconductor element 640 forms a metal-semiconductor junction. The BPR 636 and n-type semiconductor element 670 forms another metal-semiconductor junction. Given the presence of the metal-semiconductor junctions/Schottky barriers, the SCR conducts current only in one direction. For example, the SCR can be triggered by a positive current applied to the SCR.

The TSVs 683 and 687 are in the semiconductor section 610 and are connected to the BPRs 530 and 535. The TSVs 683 and 687 are connected to the electrically conductive layer 690. Accordingly, the TSVs 683 and 687 couple the BPRs 530 and 535 to the electrically conductive layer 690.

The electrically conductive layer 690 adjoins the support structure 605, more specifically adjoins the backside 685 of the support structure 605. The electrically conductive layer 690 may be a power plane, a ground plane, or a combination of both. As the electrically conductive layer 690 is at the backside 685, the BPRs 630 and 635 and TSVs 683 and 687 can facilitate backside power delivery. The electrically conductive layer 690 adjoins the semiconductor section 610. The electrically conductive layer 690 may be insulated from the semiconductor section 610 by an insulator (not shown in FIG. 6), such as a dielectric barrier at the interface of the electrically conductive layer 690 and semiconductor section 610, an insulator layer between the electrically conductive layer 690 and semiconductor section 610, etc. In some embodiments, the IC device 600 includes transistors and an additional electrically conductive layer electrically coupled to semiconductor structures. The additional electrically conductive layer can also be coupled to the BPRs 630 and 635 so that the electrically conductive layer and BPRs 630 and 635 can provide electrical power to the semiconductor structures from the backside 685. Example semiconductor structures include fins, nanoribbons, nanosheets, and so on.

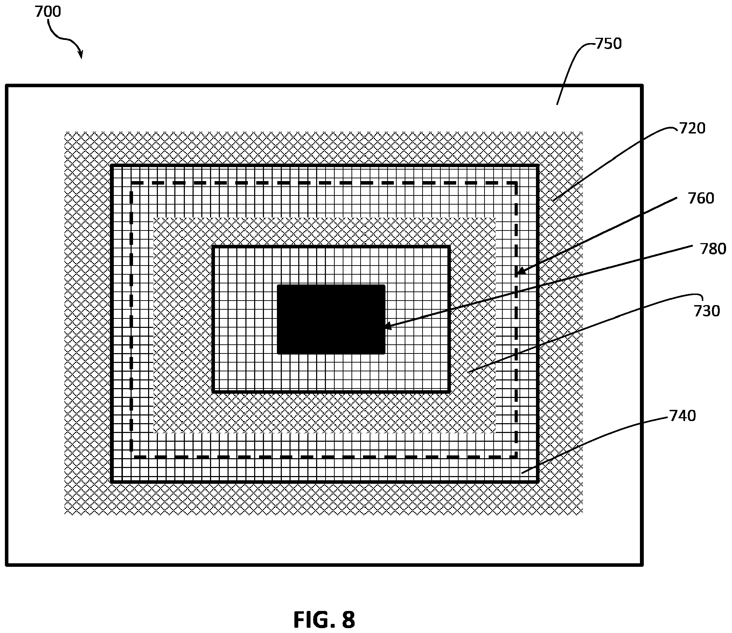

FIG. 7 is a cross-sectional view of an example IC device 700 including a BPR-based guard ring, according to some embodiments of the disclosure. FIG. 8 is a top view of the example IC device 700 in FIG. 7, according to some embodiments of the disclosure. The IC device 700 includes a support structure 705, a power plane 775, a ground plane 777, and an IP pad 780.

The support structure 705 includes a semiconductor section 710, an insulator section 740, and BPRs 720 and 730. The semiconductor section 710 includes a semiconductor material. The insulator section 740 includes an electrically insulation material, such as silicon oxide. The insulator section 740 insulates the BPRs 720 and 730 from each other. The two BPRs 720 and 730 are buried in the support structure 705. In the embodiment of FIGS. 7 and 8, the two BPRs 720 and 730 are ring-shaped. As shown in FIG. 8, the BPR 720 encloses the BPR 730. A portion of each BPR 720 or 730 contacts with the insulator section 740. The remaining portion of the BPR 720 or 730 contacts with the semiconductor section 710. The BPRs 720 and 730 do not have dielectric barriers that separate their metal cores from the semiconductor section 710. Thus, the BPRs 720 and 730 form metal-semiconductor junctions with the semiconductor section 710. The semiconductor section 710 includes a n-type semiconductor element 750 and a p-type semiconductor element 760. The n-type semiconductor element 750 may be an n-well formed in the semiconductor section 710. A concentration of an-type dopant in the n-well is higher than a concentration of the n-type dopant in the support structure outside the n-well 705. The p-type semiconductor element 760 may be a p-well formed in the semiconductor section 710. A concentration of a p-type dopant in the p-well is higher than a concentration of the p-type dopant in the support structure 705 outside the p-well. The n-type semiconductor element 750 and p-type semiconductor element 760 are also ring-shaped. As shown in FIG. 8, the n-type semiconductor element 750 encloses the p-type semiconductor element 760. The p-type semiconductor element 760 is coupled to the IO (input/output) pad 780 that provides input/output signals. The BPR 720 is buried in and contacts with the n-type semiconductor element 750. The BPR 730 is buried in and contacts with the p-type semiconductor element 760.

In some embodiments, the BPR 720 is coupled to the power plane 775, e.g., a power plane having a positive voltage. The BPR 730 is coupled to the ground plane 777. Thus, the power plane 775 and ground plane 777 are connected to the Schottky barriers formed by the BPRs 720 and 730 with the n-type semiconductor element 750 and p-type semiconductor element 760. Given the connection of the Schottky barriers to the power plane 775 and ground plane 777, one or both of the Schottky barriers (i.e., one or both of the metal-semiconductor junction between the BPR 720 and n-type semiconductor element 750 and the metal-semiconductor junction between the BPR 730 and p-type semiconductor element 760) constitute a latch-up guard ring. The latch-up guard ring can extract injected charge carriers that have been injected at a nearby junction and therefore, prevents formation of electrical current paths between the power plane 775 and ground plane 777.

In some embodiments, each BPR 720 or 730 is formed by a deep trench in the 50 -150 nm range. The deep trench can be filled with a metal. In some embodiments, a metal with a lower diffusion tendency into Si is used to reduce the thickness of liners in the trench. Examples of the metal include Tungsten, Rubidium, Molybdenum, and so on. In some embodiments, the deep trench is filled with Tungsten or Molybdenum to reduce the Schottky barrier height. In the process of forming the BPR 720 or 730, the deep trench is not covered by any insulating layers or liners to avoid formation of any insulating layers or liners that will separate the metal from the semiconductor in the n-type semiconductor element 750 and p-type semiconductor element 760. With the depth of the deep trench, the latch-up guard ring can have a high guarding efficiency. Also, the usage of the BPRs 720 and 730 to form the latch-up guard ring saves space in the IC device 700. Further, the BPRs 720 and 730 can be fabricated with minor changes to the process of fabricating BPRs having dielectric barriers. In some embodiments, a mask is used in the process of fabricating the IC device 700 to block or remove insulating layer inside the deep trench.

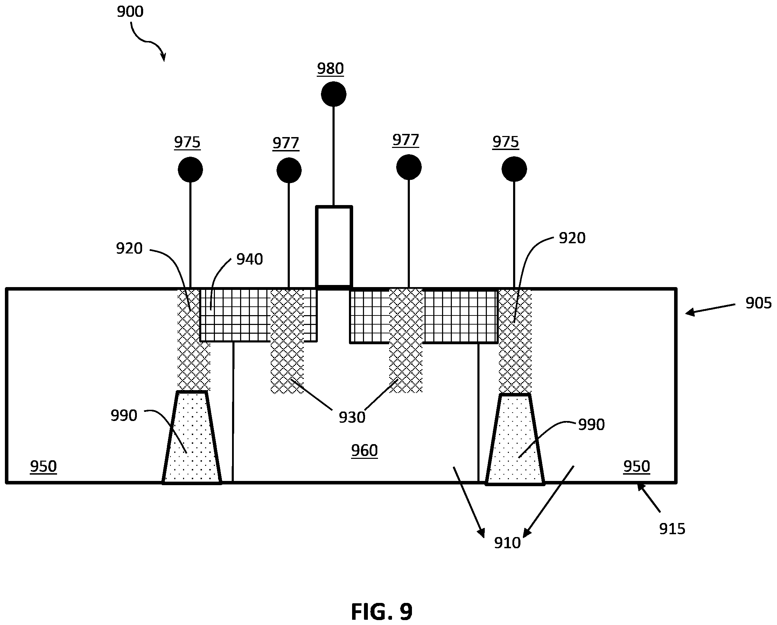

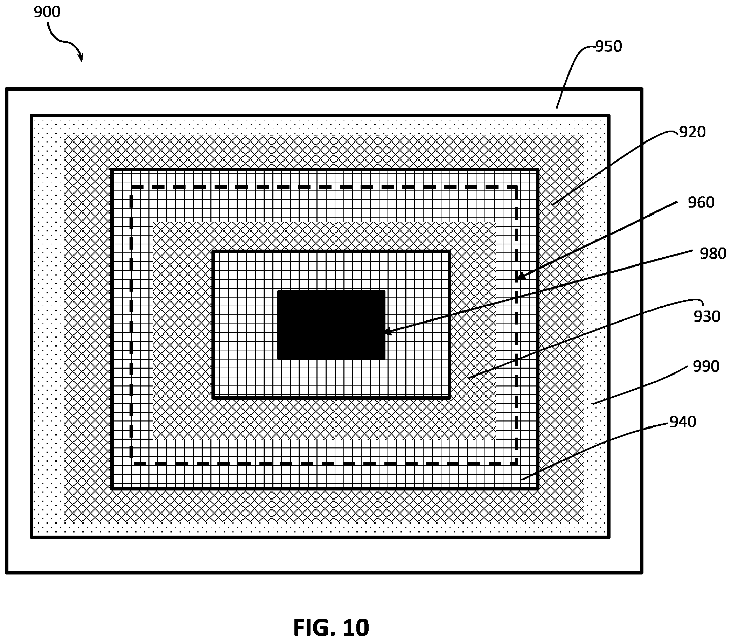

FIG. 9 is a cross-sectional view of another example IC device 900 including a BPR-based guard ring, according to some embodiments of the disclosure. FIG. 10 is a top view of the example IC device 900 in FIG. 9, according to some embodiments of the disclosure. The IC device 900 includes a semiconductor section 910. The semiconductor section 910 may be an embodiment of the semiconductor section 430 in FIG. 4. The IC device 900 includes a support structure 905, a power plane 975, a ground plane 977, and an IO pad 980. In other embodiments, the IC device 900 may include fewer, more, or different components.

The support structure 905 includes a semiconductor section 910, an insulator section 940, two BPRs 920 and 930, and a TSV 990. The semiconductor section 910 may be an embodiment of the semiconductor section 710 in FIG. 7. The insulator section 940 may be an embodiment of the insulator section 740 in FIG. 7. The TSV 990 is connected to the BPR 920 but is insulated from the BPR 930. Similar to the BPRs 720 and 730 in FIG. 7, the two BPRs 920 and 930 do not have dielectric barriers that separate their metal cores from the semiconductor section 910. The BPRs 920 and 930 may be formed by a process that is the same as or similar to the process forming the BPRs 720 and 730 in FIG. 7. Thus, the BPRs 920 and 930 form metal-semiconductor junctions with the semiconductor section 910. As shown in FIG. 10, the two BPRs 920 and 930 are ring-shaped and the BPR 920 encloses the BPR 930.

The semiconductor section 910 includes a n-type semiconductor element 950 and a p-type semiconductor element 960 . The n-type semiconductor element 950 and p-type semiconductor element 960 are also ring-shaped. As shown in FIG. 10, the n-type semiconductor element 950 encloses the p-type semiconductor element 960. The p-type semiconductor element 960 is coupled to an IO (input/output) pad that provides input/output signals. The BPR 920 is buried in the n-type semiconductor element 950 . The BPR 930 is buried in the p-type semiconductor element 960 . The two BPRs 920 and 930 are insulated from each other by an insulator 940. An embodiment of the insulator 940 includes an oxide material, such as silicon oxide.

The BPR 920 and TSV 990 are coupled to the power plane 975, e.g., a power plane having a positive voltage. The BPR 930 is coupled to the ground plane 977. Thus, the power plane 975 and ground plane 977 are connected to the Schottky barriers formed by the BPRs 920 and 930 with the n-type semiconductor element 950 and p-type semiconductor element 960. Given the connection of the Schottky barriers to the power plane 995 and ground plane 999, one or both of the Schottky barriers (i.e., one or both of the metal-semiconductor junction between the BPR 920 and n-type semiconductor element 950 and the metal-semiconductor junction between the BPR 930 and p-type semiconductor element 960) constitute a latch-up guard ring. The latch-up guard ring can extract injected charge carriers that have been injected at a nearby junction and therefore, prevents formation of electrical current paths between the power plane and ground plane.

The TSV 990 can enhance the efficiency of the latch-up guard ring. As shown in FIG. 9, the TSV 990 is buried in the n-type semiconductor element 950 and connects the BPR 920 to the backside 915 of the semiconductor section 910, i.e., the backside 915 of the IC device 900. In some embodiments, an electrically conductive layer (not shown in FIG. 9), e.g., a metal layer, can be arranged at the backside. Thus, the TSV 990 forms a conductive path from the power plane 975 to the BPR 920 and further to the electrically conductive layer at the backside. Such as conductive path can increase the efficiency of extracting injected charge carriers and therefore, improves the efficiency of the latch-up guard ring.

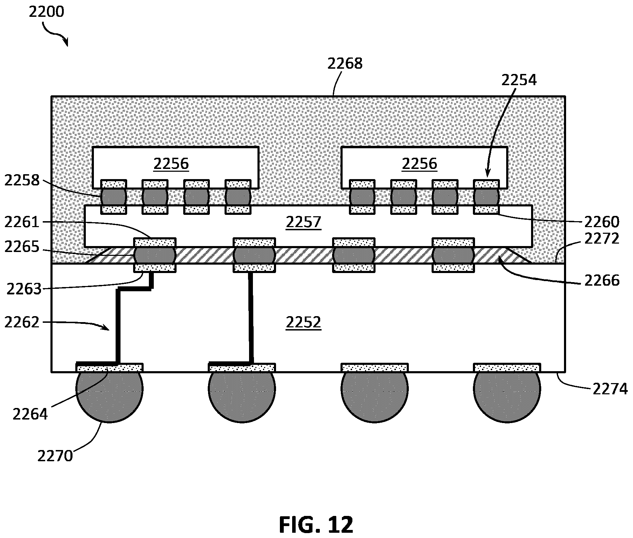

FIGS. 11A-11B are top views of a wafer 2000 and dies 2002 that may include one or more metal-semiconductor junctions formed by BPRs, according to some embodiments of the disclosure. In some embodiments, the dies 2002 may be included in an IC package, according to some embodiments of the disclosure. For example, any of the dies 2002 may serve as any of the dies 2256 in an IC package 2200 shown in FIG. 12. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs including one or more BPRs as described herein). After the fabrication of the semiconductor product is complete (e.g., after manufacture of one or more BPRs as described herein), the wafer 2000 may undergo a singulation process in which each of the dies 2002 is separated from one another to provide discrete "chips" of the semiconductor product. In particular, devices that include one or more BPRs as disclosed herein may take the form of the wafer 2000 (e.g., not singulated) or the form of the die 2002 (e.g., singulated). The die 2002 may include one or more diodes (e.g., one or more BPRs as described herein), one or more transistors (e.g., one or more III-N transistors as described herein) as well as, optionally, supporting circuitry to route electrical signals to the III-N diodes with n-doped wells and capping layers and III-N transistors, as well as any other IC components. In some embodiments, the wafer 2000 or the die 2002 may implement an electrostatic discharge (ESD) protection device, an RF FE device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 12 is a side, cross-sectional view of an example IC package 2200 that may include one or more IC devices having metal-semiconductor junctions formed by BPRs, according to some embodiments of the disclosure. In some embodiments, the IC package 2200 may be a system-in-package (SiP).

As shown in FIG. 12, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 12 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 12 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

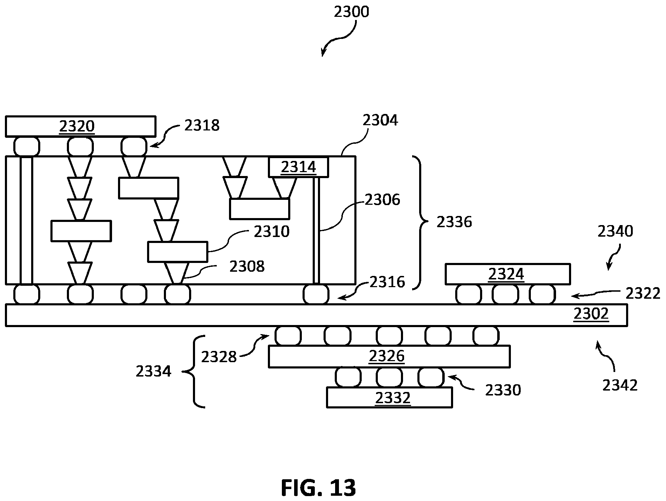

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 12 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 13.

The dies 2256 may take the form of any of the embodiments of the die 2002 discussed herein and may include any of the embodiments of an IC device having one or more BPRs. In embodiments in which the IC package 2200 includes multiple dies 2256, the IC package 2200 may be referred to as a multi-chip package. Importantly, even in such embodiments of an MCP implementation of the IC package 2200, one or more BPRs may be provided in a single chip, in accordance with any of the embodiments described herein. The dies 2256 may include circuitry to perform any desired functionality. For example, one or more of the dies 2256 may be ESD protection dies, including one or more BPRs as described herein, one or more of the dies 2256 may be logic dies (e.g., silicon-based dies), one or more of the dies 2256 may be memory dies (e.g., high bandwidth memory), etc. In some embodiments, any of the dies 2256 may include one or more BPRs, e.g., as discussed above; in some embodiments, at least some of the dies 2256 may not include any III-N diodes with n-doped wells and capping layers.

The IC package 2200 illustrated in FIG. 12 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 12, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 13 is a cross-sectional side view of an IC device assembly 2300 that may include components having one or more IC devices implementing metal-semiconductor junctions formed by BPRs, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices implementing one or more BPRs in accordance with any of the embodiments disclosed herein; e.g., any of the IC packages discussed below with reference to the IC device assembly 2300 may take the form of any of the embodiments of the IC package 2200 discussed above with reference to FIG. 12 (e.g., may include one or more BPRs in/on a die 2256).

In some embodiments, the circuit board 2302 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 13 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 13), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 11B), an IC device (e.g., the IC device of FIGS. 1-2), or any other suitable component. In particular, the IC package 2320 may include one or more BPRs as described herein. Although a single IC package 2320 is shown in FIG. 13, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 13, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-substrate vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF devices, power amplifiers, power management devices, antennas, arrays, sensors, and microelectromechanical systems (MEMS) devices may also be formed on the interposer 2304. In some embodiments, the IC devices implementing one or more BPRs as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 13 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

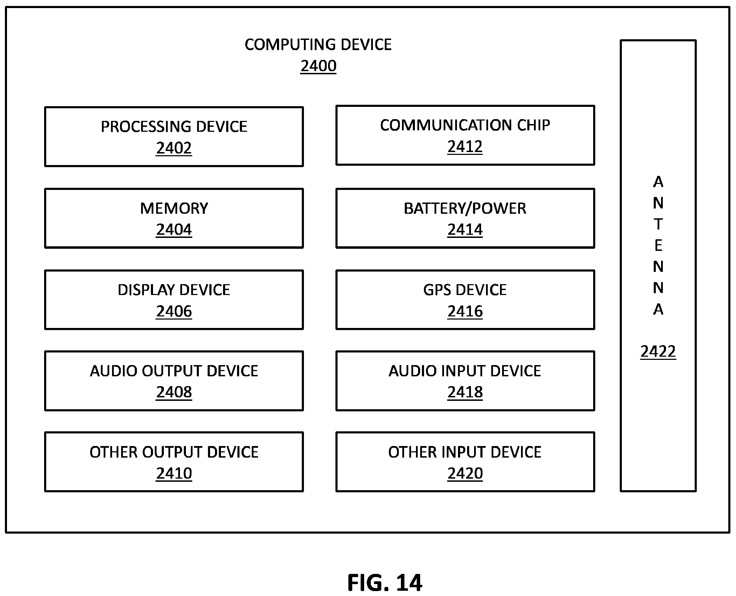

FIG. 14 is a block diagram of an example computing device 2400 that may include one or more components with one or more IC devices having one or more BPRs, according to some embodiments of the disclosure. For example, any suitable ones of the components of the computing device 2400 may include a die (e.g., the die 2002 of FIG. 11B) including one or more BPRs, according to some embodiments of the disclosure. Any of the components of the computing device 2400 may include an IC device (e.g., any embodiment of the IC devices of FIGS. 1-4) and/or an IC package (e.g., the IC package 2200 of FIG. 12). Any of the components of the computing device 2400 may include an IC device assembly (e.g., the IC device assembly 2300 of FIG. 13).

A number of components are illustrated in FIG. 14 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 14, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices having one or more BPRs as described herein may be particularly advantageous for use as part of ESD circuits protecting power amplifiers, low-noise amplifiers, filters (including arrays of filters and filter banks), switches, or other active components. In some embodiments, IC devices having one or more BPRs as described herein may be used in PMICs, e.g., as a rectifying diode for large currents. In some embodiments, IC devices having one or more BPRs as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

### Select examples

Example 1 provides an IC device, including: a support structure including a semiconductor material; a power plane including a first electrically conductive material; a ground plane including a second electrically conductive material; and a buried power rail including a metal, where the buried power rail is at least partially buried in the support structure and is coupled to the power plane or the ground plane, and a portion of the metal of the buried power rail is in contact with a portion the semiconductor material of the support structure.

Example 2 provides the IC device according to example 1, where the buried power rail is connected to a via, the via is at least partially in the support structure.

Example 3 provides the IC device according to example 1 or 2, where the buried power rail is coupled to the power plane, an additional buried power rail is coupled to the ground plane, and the additional buried power rail is at least partially buried in the support structure.

Example 4 provides the IC device according to example 3, where the additional buried power rail is connected to an additional via in the support structure, and the additional via is separated from the via by an electrical insulator.

Example 5 provides the IC device according to example 3 or 4, where the buried power rail encloses at least a portion of the additional buried power rail.

Example 6 provides the IC device according to example 5, further including: an electrical insulator between the buried power rail and additional buried power rail.

Example 7 provides the IC device according to any of the preceding examples, where the portion of the semiconductor material includes silicon.

Example 8 provides the IC device according to any of the preceding examples, where the buried power rail has a ring shape.

Example 9 provides the IC device according to any of the preceding examples, where the support structure further includes an insulator material, and another portion of the buried power rail is in contact with the insulator material.

Example 10 provides the IC device according to any of the preceding examples, where the support structure further includes: a n-well, where a concentration of a n-type dopant in the n-well is higher than a concentration of the n-type dopant in the support structure outside the n-well, a p-well, where a concentration of a p-type dopant in the p-well is higher than a concentration of the p-type dopant in the support structure outside the p-well, and the n-well encloses at least a portion of the p-well.

Example 11 provides an IC device, including: a support structure; a transistor over or at least partially in the support structure; and a layer including an electrically conductive material and coupled to the transistor, where the support structure includes: a buried power rail including a metal and coupled to the layer, and a section including a sequence of a first p-type semiconductor, a first n-type semiconductor, a second p-type semiconductor, and a second n-type semiconductor, where a portion of the metal of the buried power rail is in contact with a portion of the section.

Example 12 provides the IC device according to example 11, where the portion of the sequence includes silicon.

Example 13 provides the IC device according to example 11 or 12, where the portion of the metal of the buried power rail is in contact with the first p-type semiconductor.

Example 14 provides the IC device according to any one of the examples 11-13, where: the support structure further includes an additional buried power rail including an additional metal, the additional buried power rail is coupled to an additional layer including an additional electrically conductive material, and a portion of the additional metal of the additional buried power rail is in contact with the second n-type semiconductor.

Example 15 provides the IC device according to any one of the examples 11-14, where: the support structure further includes an additional section, the additional section includes an insulator material, and the additional section adjoins the section.

Example 16 provides the IC device according to example 15, where another portion of the metal of the buried power rail is in contact with the additional section.

Example 17 provides an IC device, including: a support structure, including: a section including a semiconductor material, a first elongated structure including a first metal, and a second elongated structure including a second metal, the second elongated structure at least partially enclosed by the first elongated structure, where a portion of the first metal or a portion of the second metal is in contact with a portion of the section; a first layer including a first electrically conductive material and coupled to the first elongated structure; and a second layer including a second electrically conductive material and coupled to the second elongated structure.

Example 18 provides the IC device according to example 17, where the first elongated structure and the second elongated structure are separated by an insulator material in the support structure.

Example 19 provides the IC device according to example 17 or 18, where: the section includes a p-type semiconductor and a n-type semiconductor, the first elongated structure is in contact with the p-type semiconductor, and the second elongated structure is in contact with the n-type semiconductor.

Example 20 provides the IC device according to any one of the examples 17-19, where: the support structure further includes a first via and a second via insulated from the first via, the first buried power rail is connected to the first via, and the second buried power rail is connected to the second via.

Example 21 provides an IC package, including the IC device according to any of the proceeding examples; and a further IC component, coupled to the IC device.

Example 22 provides the IC package according to example 21, where the further IC component includes one of a package substrate, an interposer, or a further IC die.

Example 23 provides the IC package according to example 21 or 22, where the IC device according to any one of examples 1-20 may include, or be a part of, at least one of a memory device, a computing device, a wearable device, a handheld electronic device, and a wireless communications device.

Example 24 provides an electronic device, including a carrier substrate; and one or more of the IC devices according to any one of examples 1-20 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a support structure comprising a semiconductor material;
a power plane comprising a first electrically conductive material;
a ground plane comprising a second electrically conductive material; and
a buried power rail comprising a metal, wherein the buried power rail is at least partially buried in the support structure and is coupled to the power plane or the ground plane, and a portion of the metal of the buried power rail is in contact with a portion the semiconductor material of the support structure.

2. The IC device according to claim 1, wherein the buried power rail is connected to a via, the via is at least partially in the support structure.

3. The IC device according to claim 1 or 2, wherein the buried power rail is coupled to the power plane, an additional buried power rail is coupled to the ground plane, and the additional buried power rail is at least partially buried in the support structure.

4. The IC device according to claim 3, wherein:
the additional buried power rail is connected to an additional via in the support structure, and the additional via is separated from the via by an electrical insulator; or
the buried power rail encloses at least a portion of the additional buried power rail.

5. The IC device according to any of the preceding claims, wherein the portion of the semiconductor material comprises silicon.

6. The IC device according to any of the preceding claims, wherein the buried power rail has a ring shape.

7. The IC device according to any of the preceding claims, wherein:
the support structure further comprises an insulator material, and another portion of the buried power rail is in contact with the insulator material; or
the support structure further comprises:
a n-well, wherein a concentration of a n-type dopant in the n-well is higher than a concentration of the n-type dopant in the support structure outside the n-well,
a p-well, wherein a concentration of a p-type dopant in the p-well is higher than a concentration of the p-type dopant in the support structure outside the p-well, and
the n-well encloses at least a portion of the p-well.

8. An integrated circuit (IC) device, comprising:
a support structure;
a transistor over or at least partially in the support structure; and
a layer comprising an electrically conductive material and coupled to the transistor,
wherein the support structure includes:
a buried power rail comprising a metal and coupled to the layer, and
a section comprising a sequence of a first p-type semiconductor, a first n-type semiconductor, a second p-type semiconductor, and a second n-type semiconductor,
wherein a portion of the metal of the buried power rail is in contact with a portion of the section.

9. The IC device according to claim 8, wherein the portion of the sequence includes silicon.

10. The IC device according to claim 8 or 9, wherein the portion of the metal of the buried power rail is in contact with the first p-type semiconductor.

11. The IC device according to any one of claims 8-10, wherein:
the support structure further comprises an additional buried power rail including an additional metal, the additional buried power rail is coupled to an additional layer comprising an additional electrically conductive material, and a portion of the additional metal of the additional buried power rail is in contact with the second n-type semiconductor; or
the support structure further comprises an additional section, the additional section comprises an insulator material, and the additional section adjoins the section.

12. An integrated circuit (IC) device, comprising:
a support structure, comprising:
a section comprising a semiconductor material,
a first elongated structure comprising a first metal, and
a second elongated structure comprising a second metal, the second elongated structure at least partially enclosed by the first elongated structure,
wherein a portion of the first metal or a portion of the second metal is in contact with a portion of the section;
a first layer comprising a first electrically conductive material and coupled to the first elongated structure; and
a second layer comprising a second electrically conductive material and coupled to the second elongated structure.

13. The IC device according to claim 12, wherein the first elongated structure and the second elongated structure are separated by an insulator material in the support structure.

14. The IC device according to claim 12 or 13, wherein:
the section comprises a p-type semiconductor and a n-type semiconductor,
the first elongated structure is in contact with the p-type semiconductor, and
the second elongated structure is in contact with the n-type semiconductor.

15. The IC device according to any one of claims 12-14, wherein:
the support structure further comprises a first via and a second via insulated from the first via,
the first buried power rail is connected to the first via, and the second buried power rail is connected to the second via.
